# EUROPÄISCHE PATENTSCHRIFT

(11) **EP 1 237 271 B1**
(45) Veröffentlichungstag und Bekanntmachung des Hinweises auf die Patenterteilung: **22.02.2012**
(21) Anmeldenummer: 01129786.8
(22) Anmeldetag: 14.12.2001
(51) Int. Cl.: H02M 7/48

(54) **Schaltungdanordnung für einen Treiber für Leistungshalbleitermodule**
Circuit arrangement for a driver for power semiconductor module
Montage de circuit pour l'attaque d'un module à semi-conducteur de puissance

(30) Priorität: 02.03.2001 DE 10110100
(43) Veröffentlichungstag der Anmeldung: 04.09.2002
(73) Patentinhaber: SEMIKRON Elektronik GmbH & Co. KG, 90431 Nürnberg (DE)
(72) Erfinder: do Nascimento, Jair, 91077 Dormitz (DE)

(56) Entgegenhaltungen:
- DE-A1- 19 630 173
- US-A- 6 049 475

## Beschreibung

Die Erfindung beschreibt eine Treiberschaltungsanordnung für ein Leistungshalbleitermodul in der Topologie einer 3- Phasen Brücke nach dem Oberbegriff des Anspruches 1. Derartige Treiberschaltungsanordnung für Leistungshalbleitermodule sind aus der Literatur bekannt. Bei der Erhöhung der Leistungsfähigkeit sowie einer Steigerung der Zuverlässigkeit der Leistungshalbleitermodule ist eine Optimierung der verwendeten Treiberschaltungsanordnung eine zwingende Voraussetzung.

In der Entwicklung von Leistungshalbleitermodulen bilden den modernen Stand der Technik kompakte Aufbauvarianten, die beispielsweise einen 3- Phasen- Brückengleichrichter in einem Gehäuse ohne Grundplatte vereinen. Derartige Aufbauten sind beispielhaft aus der DE 196 30 173 C1 bekannt. Weitere aktuelle Entwicklungen betreffen die Verringerung der parasitären Induktivitäten in Leistungshalbleitermodulen, wie beispielhaft in der DE 100 37 533 A1 vorgestellt. Die Entwicklung der in derartigen Modulen eingesetzten Leistungsschalter, die vornehmlich aus einer Parallelschaltung von mehreren Leistungstransistoren wie z.B. IGBTs (insulated gate bipolar transistor) mit parallel geschalteten Freilaufdioden bestehen, geht zu höheren Sperrspannungen. Den Stand der Technik bilden hier IGBTs der Sperrspannungsklassen 600V, 1200V, 1700V sowie 3300V.

Durch derartige kompakte Module mit steigender Leistungsfähigkeit bei verringertem Flächenbedarf steigen auch die Anforderungen an die zu ihrer Ansteuerung benötigten Treiberschaltungen.

Eine kompakte Anordnung aus Leistungshalbleitermodul und dazugehöriger Treiberschaltungsanordnung ist realisierbar indem diese direkt auf dem Leistungshalbleitermodul angeordnet ist. Eine derartige Anordnung zwingt der Treiberschaltung eine gewisse Topologie ihrer Ansteueranschlüsse an das Leistungshalbleitermodul auf.

Die Aufgabe der Treiberschaltung besteht in der Ansteuerung der Leistungsschaltern nach einem durch z.B. einen Mikroprozessor vorgegebenen Schaltmuster derart, dass die Ausgangsspannung des Leistungshalbleitermoduls einer für den jeweiligen Einsatzzweck idealen Ausgangsspannung weitestgehend entspricht. Zu diesem Zweck besteht die Treiberschaltungsanordnung aus eine Vielzahl aktiver sowie passiver Bauelemente.

Eine wesentlich Rolle kommt bei der genannten Aufgabe der Pegelanpassung der Ansteuersignale der Leistungsschalter zu. Diese Pegelanpassung ist in der Regel sowohl für die TOP- Schalter als auch für die BOT- Schalter einer 3- Phasen- Brückenschaltung notwendig, da das Bezugspotential auch für die BOT- Schalter nicht zwangsläufig identisch ist mit dem Bezugspotential der Treiberschaltungsanordnung.

Als Pegelanpassung kommen im wesentliche zwei Arten von Bauelement zum Einsatz, einerseits Optokoppler, anderseits Impulsübertrager. Impulsübertrager haben gegenüber Optokoppplern den Vorteil auch Leistung übertragen zu können und somit als Spannungsversorgung von Bauelemente auf der Sekundärseite der Pegelanpassung dienen zu können.

Zum Stand der Technik zählen Impulsübertrager mit zwei Steuerkanälen zur Übertragung von zwei Ansteuersignalen beispielhaft für je einen TOP- und einen BOT- Schalters sowie zwei sekundärseitigen Versorgungskanälen zur Spannungsversorgung sekundärseitiger Verbraucher. Derartige Verbraucher sind beispielhaft Bauelemente zur Korrektur der Signalform der übertragenen Ansteuersignale. Weiterhin können derartige Übertrager Signale, wie z.B. Fehlersignale, von der Sekundär- auf die Primärseite übertragen.

Treiberschaltungsanordnungen nach dem Stand der Technik ordnen jeder Phase einer 3-Phasen- Brückenschaltung einen Impulsübertrager zu. Eine solche Treiberschaltungsanordnung wird in US 6,049,475 gezeigt.

Dabei kommt es zwangsläufig zu Topologien bei denen primärseitige Signalwege von sekundärseitigen gekreuzt werden. An derartigen Kreuzungspunkten ist der Abstand zwischen den beiden sich kreuzenden Leitungen bei Verwendung gängiger Leitplatten in der Größenordnung von 1mm oder weniger.

Besonders bei Verwendung von IGBTs der Sperrspannungsklassen über 600V sind kurze Schaltzeiten der Leistungsschalter zur Erzeugung qualitativ hochwertiger Ausgangssignale des Leistungshalbleitermoduls notwendig. Dieses schnelle Schalten entspricht schnellen Spannungsänderungen (hohes dU/dt) auf den Ansteuerleitungen.

Derartige schnelle Spannungsänderungen können an den Knotenpunkten zu Übersprechen bzw. Störspannungen auf der jeweils anderen Leitung führen. Diese Störspannungen können zu Störungen im Betrieb des Leistunghalbleitermoduls oder sogar zu dessen Ausfall führen.

Die hohen sekundärseitigen Spannungen führen zusätzlich zu Problemen mit der Isolationskoordination. Hierunter werden Effekte wie Teilentladungen im Volumen und an der Oberfläche der Leiterplatte verstanden. Weitergehende Informationen hierzu finden sich in "Kapitel 1 bei König, Rao, Teilentladungen in Betriebsmitteln der Energietechnik, VDE-Verlag 1993 ISBN 3-8007-1764-6", in der DIN EN 50178 (VDE 0160) sowie bezüglich der Auswirkungen auf Leistungshalbleiterbauelemente in der DE 100 63 714 A1.

Der Erfindung liegt die Aufgabe zugrunde eine Schaltungsanordnung für eine Treiberschaltungsanordnung zur Ansteuerung eines Leistungshalbleitermoduls in der Topologie einer 3- Phasen- Brücke mit gesteigerter Störspannungsfestigkeit sowie hoher Qualität der Isolationskoordination bei sicherer Potentialtrennung und hoher Zuverlässigkeit vorzustellen.

Die Aufgabe wird erfindungsgemäß gelöst durch die Merkmale des kennzeichnenden Teils des Anspruchs 1. Bevorzugte Ausführungsformen sind in den Unteransprüchen beschrieben.

Kompakte Leistungshalbleitermodule in 3- Phasen- Brücken- Topologie weisen spezielle konstruktive Gegebenheiten auf, da sie beispielhaft auf besonders geringe parasitäre Induktivitäten ausgelegt sind. Stand der Technik sind Leistungshalbleitermodule mit an der der Grundplatte, meist einem keramischen Substrat, abgewandten Seite herausgeführten Leistungs- sowie Ansteueranschlüssen. Durch den inneren Aufbau dieser Leistungshalbleitermodule vorgegeben befinden sich die Gleichstromanschlüsse ein einer der beiden Längsseiten, die drei Wechselstromanschlüsse an der gegenüberliegenden. Die Mehrzahl der Ansteueranschlüsse befindet sich ebenfalls an den Längsseiten des Leistungshalbleitermoduls. Hierbei handelt es sich typischerweise um die Gate- sowie die Hilfsemitteranschlüsse. Bei dieser Aufbautopologie befinden sich die Ansteueranschlüsse der BOT- Schalter auf der einen Seite, diejenigen der TOP- Schalter auf der gegenüberliegenden.

Die Leiterplatte der Treiberschaltungsanordnung befindet sich direkt oberhalb diese Ansteueranschlüsse auf dem Leistungshalbleitermodul. Durch diese Anordnung können kurze Verbindungen zwischen dem Leistungshalbleitermodul und der Treiberschaltungsanordnung realisiert werden.

Die jeder der drei Phasen und somit je einem TOP- sowie einem BOT- Schalter zugeordneten Impulsübertrager befinden sich bei dieser Topologie zwischen den jeweiligen Anschlüssen auf der Leiterplatte der Treiberschaltungsanordnung. Daher ergeben sich zwangsläufig Kreuzungspunkte zwischen primärseitigen und sekundärseitigen Signalen.

Die Erfinderische Ausgestaltung der Leiterplatte der Treiberschaltungsanordnung verwendet für eine erste sowie eine zweite Phase des Wechselstroms zwei Übertrager in einer Zuordnung derart, dass die beiden TOP- Schalter der ersten und zweiten Phase einem ersten Impulsübertrager zugeordnet sind sowie die beiden BOT- Schalter der ersten und zweiten Phase einem zweiten Impulsübertrager zugeordnet sind. Die Zuordnung des dritten Impulsübertrager bleibt gegenüber dem Stand der Technik unverändert. Die Zuordnung des ersten bzw. zweiten Impulsübertragers zu den TOP- bzw. BOT- Schaltern der ersten und zweiten Phase weist folgende erfinderisch Vorteile gegenüber dem Stand der Technik auf:
- Die Anordnung des jeweiligen Impulsübertragers kann nahe an den entsprechenden mit Signalen zu versorgenden Anschlüssen vorgenommen werden. Somit ist ein Kreuzung zwischen primärseitigen und sekundärseitigen Verbindungen verhindert. Daher sind auch die Gefahren durch Übersprechen bzw. Störspannungen auf eine gekreuzte anderen Leitung unterbunden, ein störsicherer Betrieb des Leistungshalbleiterbauelements ist somit gewährleistet.
- Die Abstände der primärseitigen zu den sekundärseitigen Leitungen wird um eine Größenordnung auf 10mm oder mehr erhöht. Damit können die hohen sekundärseitigen Spannungen nicht mehr zu zusätzlich Problemen mit der Isolationskoordination führen, da sämtliche relevanten Strecken deutlich vergrößert wurden.

Dieser deutlichen Gewinn an Zuverlässigkeit der Treiberschaltungsanordnung führt auch direkt zu einer der Erhöhung der Leistungsfähigkeit sowie einer Steigerung der Zuverlässigkeit des Systems aus Leistungshalbleitermodul und der zugehörigen Treiberschaltungsanordnung.

Der erfinderisch Gedanke wird anhand der Ausführungsbeispiele in den Fig. 1 bis 3 näher erläutert.
- Fig. 1: zeigt das Layout eines Leistungshalbleitermoduls nach dem Stand der Technik.
- Fig. 2: zeigt eine Treiberschaltungsanordnung für ein Leistungshalbleitermodul nach dem Stand der Technik.
- Fig. 3: zeigt eine erfinderische Ausgestaltung eine Treiberschaltungsanordnung für ein Leistungshalbleitermodul.

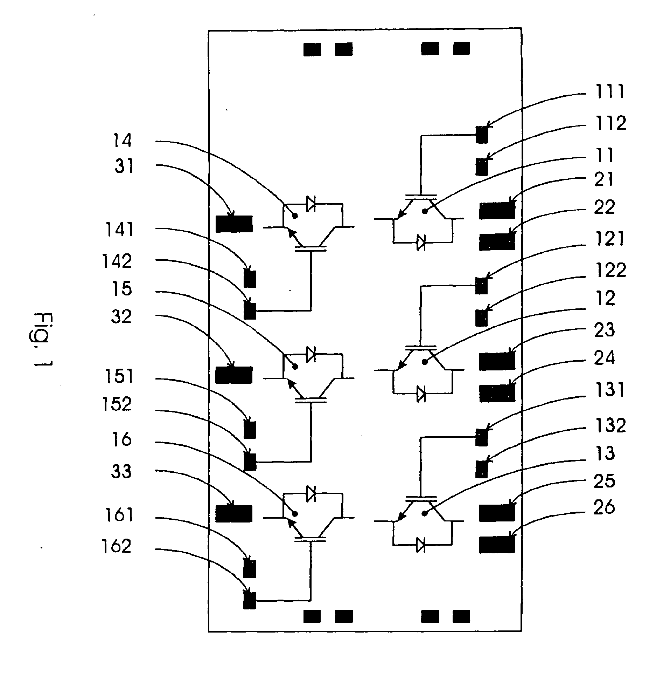

Ein kompaktes Leistungshalbleitermodul in 3- Phasen- Brücken- Topologie nach Fig. 1 besteht neben einer Grundplatte, aus den Leistungsschaltern 11-16 sowie einem Gehäuse mit an dessen Oberseite befindlichen Leistungs- und Ansteueranschlüssen. Der Übersichlichkeit halber sind die Leistungsschalter nur skizziert und nicht als eine Anzahl einzelner Leistungstransistoren gezeichnet. Der BOT- Schalter 11 ist direkt benachbart zum TOP- Schalter 14 der ersten Phase, ebenso die BOT- 12 und TOP- Schalter 15 der zweiten Phase bzw. die BOT- 13 und TOP- Schalter 16 der dritten Phase. Der Gate- 111 sowie der Hilfsemitteranschluss 112 des BOT- Schalters 11 der ersten Phase liegt eng benachbart zu diesem, ebenso die entsprechenden Anschlüsse der anderen Leistungsschalter.

Die Minus- 21, 23, 25 sowie Pluspole 22, 24 ,26 der Anschlüsse des Gleichstromzwischenkreises liegen an der ersten Längsseite die 3 Phasen 31, 32, 33 der Wechselstromanschlüsse an der zweiten Längsseite. Auf die Darstellung der internen Verschaltung wurde verzichtet.

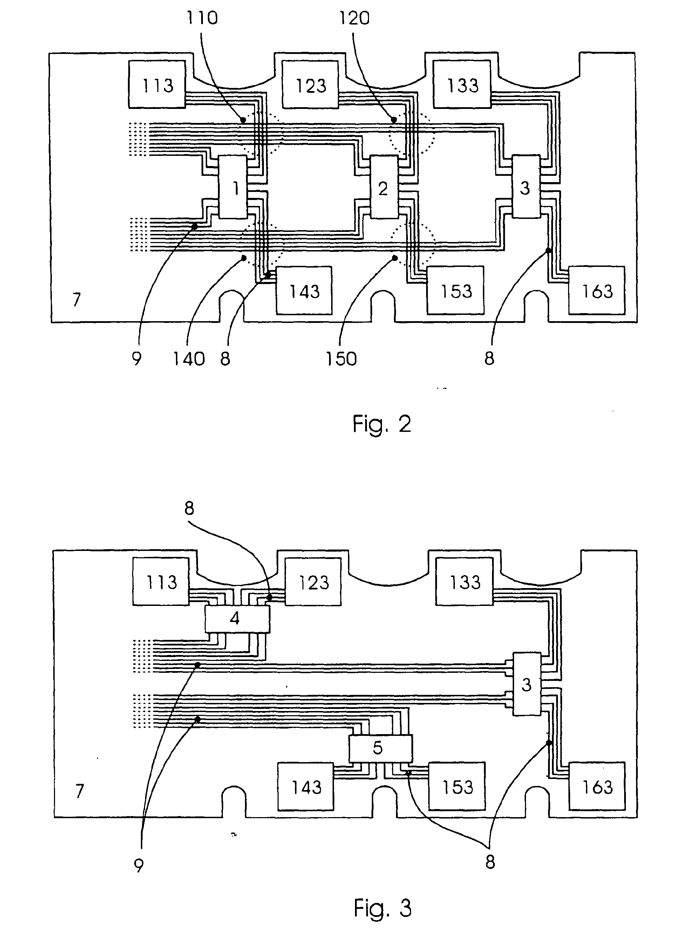

Fig. 2 zeigt den Stand der Technik einer Treiberschaltungsanordnung zur direkten Montage auf einem Leistungshalbleitermodul nach Fig. 1. Die sekundärseitigen Bauelemente 113 der Ansteuerschaltung einschließlich der Anschlüsse 111, 112 zum Leistungshalbleitermodul des BOT- Schalters 11 der ersten Phase werden aus dem Impulsübertrager 1 versorgt. Der Impulsübertrager 1 versorgt ebenso die sekundärseitigen Bauelemente 143 der Ansteuerschaltung einschließlich der Anschlüsse 141, 142 zum Leistungshalbleitermodul des TOP- Schalters 14. Analog versorgt der Impulsübertrager 2 bzw. 3 die entsprechenden sekundärseitigen Bauelement der zweiten bzw. dritten Phase.

Alle Kreuzungspunkte 110, 120, 130, 140 zwischen primärseitigen 9 und sekundärseitigen Leitungen 8 sind die Ausgangspunkte für Störungen wie oben beschrieben.

Fig. 3 zeigt eine erfinderische Ausgestaltung einer Treiberschaltungsanordnung zur direkten Montage auf einem Leistungshalbleitermodul nach Fig. 1. Der für die Versorgung von zwei Leistungschaltern geeignete Impulsübertrager 4 versorgt einerseits die sekundärseitigen Bauelemente 113 der Ansteuerschaltung des BOT- Schalters 11 der ersten Phase. Diese Bauelemente 113 befinden sich direkt bei den Ansteueranschlüssen 111, 112 zum Leistungsschalters 11 des Leistungshalbleitermoduls. Der Impulsübertrager 4 versorgt weiterhin die sekundärseitigen Bauelemente 123 der Ansteuerschaltung des BOT-Schalters 12 der zweiten Phase. Diese Bauelemente 123 befinden sich direkt bei den Ansteueranschlüssen 121, 122 zum Leistungsschalters 12 des Leistungshalbleitermoduls.

Der Impulsübertrager 5 versorgt einerseits die sekundärseitigen Bauelemente 143 der Ansteuerschaltung des TOP- Schalters 14 der ersten Phase. Diese Bauelemente 143 befinden sich direkt bei den Ansteueranschlüssen 141, 142 zum Leistungsschalters 14 des Leistungshalbleitermoduls. Weiterhin versorgt der Impulsübertrager 4 die sekundärseitigen Bauelemente 123 der Ansteuerschaltung des BOT- Schalters 12 der zweiten Phase. Diese Bauelemente 123 befinden sich direkt bei den Ansteueranschlüssen 121, 122 zum Leistungsschalters 12 des Leistungshalbleitermoduls.

Der Impulsübertrager 3 versorgt wie beim Stand der Technik die entsprechenden Bauelement der dritten Phase.

Durch die beschriebene Veränderung der Versorgung können die Impulsübertrager 4 bzw. 5 nach an den sekundärseitigen Bauelementen 113 bzw. 114 plaziert werden. Durch dieses Ausgestaltung können die primärseitigen Leitungen 9 kreuzungsfrei bezüglich der sekundärseitigen 8 Leitungen geführt werden. Die beim Stand der Technik beschriebenen Nachteile bezüglich des Übersprechens, der Störspannungen bzw. der Isolationskoordination treten nicht mehr auf. Alle sekundärseitigen Leitungen 8 weisen eine Abstand von mindestens 10mm zur nächstgelegen primärseitigen Leitung 9 auf. Dieser Vergrößerung der Isolierung führte zu Vermeidung von Spannungsüberschlägen.

Ein weitere Vorteil der erfinderischen Lösung sind die großen nicht stromdurchflossenen Flächen der Leiterplatte der Treiberschaltungsanordnung. Diese Flächen sind vorteilhaft zur Abschirmung der primärseitigen Leitungen zueinander einzusetzen.

## Patentansprüche

1. Treiberschaltungsanordnung für kompakte Leistungshalbleitermodule in 3- Phasen-Brücken- Topologie bestehend aus mindestens einer Leiterplatte (7) mit aktiven sowie passiven Bauelementen, drei Impulsübertragern (4), (5), (3) für je zwei Ansteuersignale sowie je zwei Spannungsversorgungen sekundärseitiger Bauelemente (113), (123), (133), (143), (153), (163)
**gekennzeichnet dadurch, dass**
sich primärseitige Leitungen (9) nicht mit sekundärseitigen Leitungen (8) kreuzen (110), (120), (130), (140), indem ein erster Impulsübertrager (5) für die beiden TOP- Schalter (14), (15) der ersten sowie zweiten Phase, ein zweiter Impulsübertrager (4) für die beiden BOT- Schalter (11), (12) der ersten sowie der zweiten Phasen und eine dritter Impulsübertrager (3) für den TOP- (16) sowie den BOT- Schalter (13) der dritten Phase eingesetzt wird, wobei anstelle der Impulsübertrager (4, 5, 3) auch andere Bauelemente, wie Optokoppler oder Levelshifter, zur Pegelanpassung verwendet werden.

2. Treiberschaltungsanordnung nach Anspruch 1 **dadurch gekennzeichnet, dass** der Abstand primärseitiger Leitungen (9) zu sekundärseitigen Leitungen (8) mindestens 10mm beträgt.

3. Treiberschaltungsanordnung nach Anspruch 1 **dadurch gekennzeichnet, dass** die Leistungsschalter (11), (12), (13), (14), (15), (16) Parallelschaltungen von mindestens einem IGBT mit mindestens einer Freilaufdiode sind.

4. Treiberschaltungsanordnung nach Anspruch 1 **dadurch gekennzeichnet, dass** die Leiterplatte (7) direkt oberhalb des Leistungshalbleitermoduls angeordnet ist.

5. Treiberschaltungsanordnung nach Anspruch 1 **dadurch gekennzeichnet, dass** die Impulsübertrager (4), (5), (3) nahe an den sekundärseitigen Bauelemente sowie den Ansteueranschlüssen (111, 112, 121, 122, 131, 132, 141, 142, 151, 152, 161, 162) des Leistungshalbleitermodul angeordnet sind.

## Claims

1. A driver circuit arrangement for compact power semiconductor modules in a 3-phase bridge topology consisting of at least one circuit board (7) with active and also passive components, three pulse transformers (4), (5), (3) for each two control signals and also for each two voltage supplies of secondary side components (113), (123), (133), (143), (153), (163)
**characterised in that** primary-side lines (9) do not cross (110), (120), (130), (140) secondary-side lines (8), **in that** a first pulse transformer (5) for the two TOP switches (14), (15) of the first and also second phase, a second pulse transformer (4) for the two BOT switches (11), (12) of the first and also the second phases, and a third pulse transformer (3) for the TOP switches (16) and also the BOT switches (13) of the third phase are introduced, wherein
instead of the pulse transformers (4, 5, 3) other components, such as optocouplers or level shifters are also used for purposes of level adjustment.

2. The driver circuit arrangement in accordance with Claim 1,
**characterised in that** the separation distance between primary-side lines (9) and secondary-side lines (8) is at least 10 mm.

3. The driver circuit arrangement in accordance with Claim 1,
**characterised in that** the power switches (11), (12), (13), (14), (15), (16) are parallel circuits of at least one IGBT with at least one freewheel diode.

4. The driver circuit arrangement in accordance with Claim 1,
**characterised in that** the circuit board (7) is arranged directly above the power semiconductor module.

5. The driver circuit arrangement in accordance with Claim 1,
**characterised in that** the pulse transformers (4), (5), (3) are arranged near to the secondary-side components and also the control connections (111, 112, 121, 122, 131, 132, 141, 142, 151, 152, 161, 162) of the power semiconductor module.

## Revendications

1. Agencement de circuit d'attaque de modules à semi-conducteurs de puissance compacts dans une topologie de pont à 3 phases comprenant au moins une carte imprimée (7) avec des composants actifs et des composants passifs, trois transmetteurs d'impulsion (4), (5), (3) pour à chaque fois deux signaux d'activation et à chaque fois deux alimentations en tension de composants (113), (123), (133), (143), (153), (163) côté secondaire,
**caractérisé en ce que**
des lignes (9) côté primaire ne se croisent pas (110), (120), (130), (140) avec des lignes (8) côté secondaire, du fait qu'un premier transmetteur d'impulsion (5) est utilisé pour les deux interrupteurs TOP (14), (15) de la première et de la seconde phase, un deuxième transmetteur d'impulsion (4) pour les deux interrupteurs BOT (11), (12) de la première et de la seconde phase et un troisième transmetteur d'impulsion (3) pour l'interrupteur TOP (16) et l'interrupteur BOT (13) de la troisième phase, également d'autres composants, tels que des coupleurs optiques ou des "level shifters", étant utilisés au lieu des transmetteurs d'impulsion (4, 5, 3) pour l'adaptation du niveau.

2. Agencement de circuit d'attaque selon la revendication 1, **caractérisé en ce que** l'espacement de lignes (9) côté primaire par rapport à des lignes (8) côté secondaire est d'au moins 10 mm.

3. Agencement de circuit d'attaque selon la revendication 1, **caractérisé en ce que** les interrupteurs de puissance (11), (12), (13), (14), (15), (16) sont des circuits parallèles d'au moins un IGBT avec au moins une diode de marche à vide.

4. Agencement de circuit d'attaque selon la revendication 1, **caractérisé en ce que** la carte imprimée (7) est disposée directement au-dessus du module à semi-conducteurs de puissance.

5. Agencement de circuit d'attaque selon la revendication 1, **caractérisé en ce que** les transmetteurs d'impulsion (4), (5), (3) sont disposés à proximité des composants côté secondaire et des branchements d'activation (111, 112, 121, 122, 131, 132, 141, 142, 151, 152, 161, 162) du module à semi-conducteurs de puissance.
